# EUROPÄISCHE PATENTANMELDUNG

(11) **EP 2 620 237 A2**
(43) Veröffentlichungstag der Anmeldung: **31.07.2013**
(21) Anmeldenummer: 12196656.8
(22) Anmeldetag: 12.12.2012
(51) Int. Cl.: B22D 11/128, B22D 11/12

(54) **Strangführungsrolle und Strangführung für eine Stranggießmaschine**

(30) Priorität: 24.01.2012 AT 742012
(71) Anmelder: Siemens VAI Metals Technologies GmbH, 4031 Linz (AT)
(72) Erfinder: Reisenberger, Ewald, 4191 Vorderweißenbach (AT); Wimmer, Franz, 4752 Riedau (AT); Zanelli, Ugo, 33010 Tavagnacco (IT)
(74) Vertreter: Maier, Daniel Oliver

(57) **Zusammenfassung**

Die vorliegende Erfindung betrifft eine Strangführungsrolle (3, 3a, 3b) zur Führung eines Strangs (2) und eine Strangführung zur Führung und Kühlung eines Strangs (2). Die Aufgabe der Erfindung ist es, eine Strangführungsrolle (3) und eine Strangführung darzustellen, sodass eine intensive aber dennoch möglichst gleichmäßige Kühlung des Strangs (2) erreicht werden kann. Diese Aufgabe wird durch eine Strangführungsrolle gelöst,
- wobei der Durchmesser der Mantelfläche (8) größer ist als der Durchmesser den Stützwellen (7a, 7b);
- wobei die erste Stützwelle (7a) eine erste konkave Kontur (9) aufweist, die durch ein in axialer Richtung zur Mantelfläche (8) hin monoton ansteigendes Polynom zweiter oder höherer Ordnung gegeben ist; und
- wobei die zweite Stützwelle (7b) eine zweite konkave Kontur (10) aufweist, die durch ein in axialer Richtung von der Mantelfläche (8) her monoton abfallendes Polynom zweiter oder höherer Ordnung gegeben ist.

## Beschreibung

### Gebiet der Technik

Die vorliegende Erfindung betrifft eine Strangführungsrolle zur Führung eines Strangs und eine Strangführung zur Führung und Kühlung eines Strangs.

Einerseits betrifft die Erfindung eine Strangführungsrolle zur Führung eines Strangs, aufweisend
- eine erste Stützwelle mit einem ersten Lagersitz;
- eine Mantelfläche, die der ersten Stützwelle in axialer Richtung nachgelagert ist; und
- eine zweite Stützwelle mit einem zweiten Lagersitz, die der Mantelfläche in axialer Richtung nachgelagert ist.

Andererseits betrifft die Erfindung eine Strangführung zur Führung und Kühlung eines Strangs, aufweisend
- eine erste Strangführungsrolle nach einem der Ansprüche 1 bis 9, die zumindest eine konkave Kontur aufweist;
- eine zweite Strangführungsrolle nach einem der Ansprüche 1 bis 9, die zumindest eine weitere konkave Kontur aufweist, wobei beide Strangführungsrollen derselben Seite des Strangs zugeordnet sind und die zweite Strangführungsrolle der ersten Strangführungsrolle in Gießrichtung nachgelagert ist; und
- zumindest eine Kühldüse zum Aufbringen eines Kühlfluids auf dieselbe Seite des Strangs, wobei die Kühldüse in Gießrichtung zwischen der ersten und der zweiten Strangführungsrolle angeordnet ist.

Strangführungsrollen dienen dazu, einen zumindest teilerstarrten Strang - der in der Kokille der Stranggießmaschine aus metallischer Schmelze, vorzugsweise Stahlschmelze, gebildet wird - zu führen, stützen und gegebenenfalls weiter abzukühlen. Insbesondere bei hohen Gießgeschwindigkeiten ist es vorteilhaft, wenn die Strangführung zur Vermeidung bzw. Verringerung von unzulässigen Ausbauchungen (engl. *bulging*) eine möglichst enge Rollenteilung aufweist als auch eine intensive, möglichst homogene Sekundärkühlung des Strangs ermöglicht. Aufgrund der Strangbiegungs- bzw. Rückbiegungskräfte in einer bogenförmigen Strangführung bzw. der Reduktionskräfte bei einer Liquid- oder einer *Soft-Core-Reduction* in Verbindung mit den maximal zulässigen Spannungen bzw. Dehnungen des Rollenwerkstoffs, kann der Durchmesser einer Strangführungsrolle nicht beliebig klein gewählt werden, sodass sich ein minimaler Rollendurchmesser und in Folge eine minimale Rollenteilung ergibt. Problematisch an einer sehr engen Rollenteilung ist, dass der Kühlmittelstrahl einer Kühldüse gegebenenfalls nicht mehr zwischen den Strangführungsrollen durchdringen kann, sodass weder eine intensive noch eine homogene Kühlung des Strangs gewährleistet werden kann.

### Stand der Technik

Um eine unzulässige Ausbauchung des Strangs zu vermeiden, ist es technisch üblich, die maximale Gießgeschwindigkeit in der Stranggießmaschine zu beschränken. Damit wird bei gegebener Kühlintensität eine bestimmte Mindestdicke der Strangschale sichergestellt; allerdings beschränkt diese Maßnahme auch die maximale Produktionsleistung der Gießmaschine bzw. einer Gieß-Walz-Verbundanlage.

Um dennoch eine enge Rollenteilung erreichen zu können, müssen somit Abstriche bei der max. Intensität und/oder der Homogenität der Strangkühlung in Kauf genommen werden. Bei Strangführungen nach dem Stand der Technik ist es üblich, dass ein großer Teil des Kühlmittelstrahls von zumindest einer Strangführungsrolle abgedeckt wird, wodurch die Gleichmäßigkeit als auch die maximal erreichbare Kühlintensität der Strangkühlung leidet.

Konkrete Anweisungen, wie eine Strangführungsrolle mit gegebenem Manteldurchmesser bzw. eine Strangführung mit gegebener Rollenteilung gestaltet werden kann, sodass eine gleichmäßige als auch eine hohe Intensität der Strangkühlung erreicht wird, können dem Stand der Technik nicht entnommen werden.

### Zusammenfassung der Erfindung

Die Aufgabe der Erfindung ist es, die Nachteile des Stands der Technik zu überwinden und eine Strangführungsrolle zur Führung eines Strangs als auch eine Strangführung zur Führung und Kühlung eines Strangs darzustellen, sodass eine intensive aber dennoch möglichst gleichmäßige Kühlung des Strangs erreicht werden kann.

Diese Aufgabe wird einerseits durch eine Strangführungsrolle der eingangs genannten Art gelöst,
- wobei der Durchmesser der Mantelfläche größer ist als der Durchmesser den Stützwellen;
- wobei die erste Stützwelle eine erste konkave Kontur aufweist, die durch ein in axialer Richtung zur Mantelfläche hin monoton ansteigendes Polynom zweiter oder höherer Ordnung gegeben ist; und
- wobei die zweite Stützwelle eine zweite konkave Kontur aufweist, die durch ein in axialer Richtung von der Mantelfläche her monoton abfallendes Polynom zweiter oder höherer Ordnung gegeben ist.

Vorteilhafte Ausführungsformen sind Gegenstand der abhängigen Ansprüche.

Durch die Wahl der Durchmesser der Mantelfläche und der Stützwellen wird sichergestellt, dass die Mantelfläche die Stützwellen überragt, sodass ein Kontakt zwischen einer Stützwelle und der Oberfläche des Strangs verhindert wird. Durch die Ausbildung der beiden Stützwellen mit jeweils einer konkaven Kontur im Bereich zwischen dem ersten Lagersitz und dem Mantelfläche bzw. der Mantelfläche und dem zweiten Lagersitz wird erreicht, dass zwei Kühlmittelstrahlen - die beiderseits der Mantelfläche verlaufen - im Wesentlichen ungehindert auf eine Strangoberfläche auftreffen können, ohne dass ein Strahl durch eine Strangführungsrolle abgeblockt bzw. abgelenkt wird. Da somit der Kühlmittelstrahl auf dem Weg zur Strangoberfläche nicht abgebremst wird, ergibt sich eine gleichmäßig hohe Kühlintensität. Im Allgemeinen weist die Mantelfläche eine zylindrische Kontur oder eine bombierte, d.h. eine leicht nach außen gewölbte, Kontur auf.

Dem Fachmann ist bekannt, dass man eine Funktion (z.B. eine konkave Kontur) durch eine Reihe polynomialer Funktionen (vgl. Taylor-Reihe) bzw. gleichwertig auch durch eine Reihe transienter Funktionen (vgl. Fourier-Reihe) approximieren kann. Somit sollen durch den Anspruch sowohl Konturen, die durch Polynome oder transiente Funktionen (z.B. Sinus oder Kosinus) angegeben werden, miterfasst sein.

Bei einem Strang mit Knüppel- oder Vorblockprofil ist es vorteilhaft, dass die Strangführungsrolle genau eine, zylindrische oder bombierte, Mantelfläche aufweist und die erste Stützwelle symmetrisch zur zweiten Stützwelle ausgebildet ist. Somit ergibt sich eine symmetrische Rolle, wobei bei einer horizontal liegenden Rolle die Symmetrieachse in vertikaler Richtung mittig durch die Mantelfläche verläuft. Dabei ist es vorteilhaft, die Mantelfläche mittig bzgl. der Gießachse des Strangs anzuordnen, sodass der mittlere Bereich (der Bereich der potenziell größten Ausbauchung) des Strangs besonders effizient gestützt wird. Dadurch können Ausbauchungen des Strangs effizient verhindert werden.

Insbesondere bei der Führung breiter Stränge (z.B. großformatige Vorblock-, Brammen oder auch Dünnbrammenquerschnitte) ist es vorteilhaft, wenn die Strangführungsrolle mehrere, i.A. zylindrische, Mantelflächen aufweist.

Insbesondere bei einer Ausführungsform mit einer (zentralen) Mantelfläche ist es vorteilhaft, wenn sich die erste Kontur im Wesentlichen vom ersten Lagersitz bis zur Mantelfläche erstreckt, und sich die zweite Kontur im Wesentlichen von der Mantelfläche bis zum zweiten Lagersitz erstreckt.

Für eine gleichmäßige Strangkühlung ist es vorteilhaft, wenn zwischen zwei Mantelflächen eine weitere zweite Kontur und nachfolgend eine weitere erste Kontur angeordnet sind.

Um die Durchbiegung der Strangführungsrolle zu minimieren, ist es vorteilhaft, wenn zwischen der weiteren zweiten Kontur und der weiteren ersten Kontur ein Lagerbereich angeordnet ist.

Um eine Überhitzung der Strangführungsrolle zu vermeiden bzw. die Kühlintensität der Sekundärkühlung weiter steigern zu können, ist es vorteilhaft, wenn die Strangführungsrolle eine Innenkühlung, vorzugsweise mit einem Kühlmittelkanal der sich in axialer Richtung erstreckt, aufweist.

Die Aufgabe der Erfindung wird ebenfalls durch eine Strangführung der eingangs genannten Art gelöst,
- wobei die Kühldüse in einem Schnittpunkt angeordnet ist, der durch eine erste Normale auf die konkave Kontur der ersten Strangführungsrolle und eine zweite Normale auf die weitere konkave Kontur der zweiten Strangführungsrolle bestimmt ist.

Vorteilhafte Ausführungsformen sind Gegenstand der abhängigen Ansprüche.

Dadurch ist sichergestellt, dass ein Kühlmittelstrahl der Kühldüse zentrisch zu den beiden Konturen liegt, sodass er möglichst wenig, idealerweise überhaupt nicht, durch die Strangführungsrollen abgelenkt wird.

In einem einfachen Fall, weist die erste und die zweite Strangführungsrolle jeweils eine kreisbogenförmige konkave Kontur aufweist, sodass die Kühldüse im Mittelpunkt der beiden Konturen angeordnet ist bzw. die Konturen konzentrisch zur Kühldüse angeordnet sind.

Eine gleichmäßige Stützung des Strangs kann erreicht werden, wenn die Strangführungsrolle symmetrisch zu einer Längsachse des Strangs angeordnet ist.

### Kurze Beschreibung der Zeichnungen

Weitere Vorteile und Merkmale der vorliegenden Erfindung ergeben sich aus der nachfolgenden Beschreibung nicht einschränkender Ausführungsbeispiele, wobei auf die folgenden Figuren Bezug genommen wird, die Folgendes zeigen:
Fig 1a und 1b je eine perspektivische Darstellung des oberen Teils einer erfindungsgemäßen Strangführung einer Knüppel-Stranggießanlage
Fig 2a-2c eine Ansicht von links, ein Aufriss, und eine Ansicht von rechts zu Fig 1
Fig 3 eine Schnittdarstellung gemäß der Schnittlinie A-A der Fig 2c
Fig 4 eine Schnittdarstellung gemäß der Schnittlinie B-B der Fig 2c
Fig 5 und 7 je eine Darstellung zur Anordnung zweier Kühldüsen in einer Strangführung mit zwei Strangführungsrollen nach den Fig 1 bis 4
Fig 6 eine Darstellung zur Anordnung einer Kühldüse in einer Strangführung mit einer ersten Variante der Strangführungsrollen
Fig 8 eine Darstellung zur Anordnung dreier Kühldüsen in einer Strangführung mit einer zweiten Variante der Strangführungsrollen
Fig 9 eine Darstellung zur Anordnung von drei Kühldüsen in einer Strangführung mit einer dritten Variante der Strangführungsrollen zur Führung einer Bramme
Fig 10 eine Darstellung zur Anordnung von vier Kühldüsen in einer Strangführung mit einer vierten Variante der Strangführungsrollen zur Führung einer Bramme

### Beschreibung der Ausführungsformen

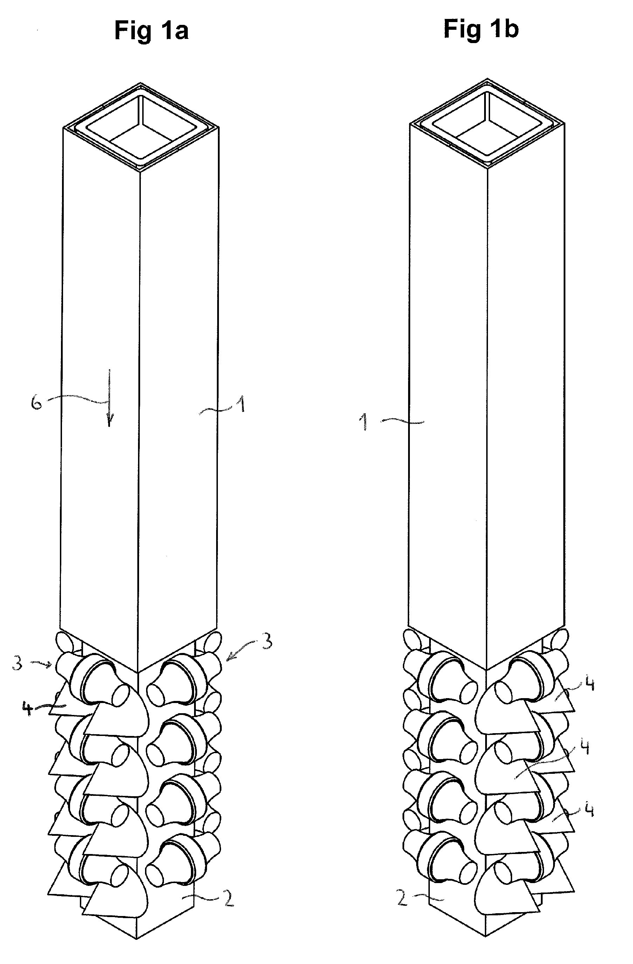

Die Fig 1 bis 5 zeigen Darstellung einer ersten Ausführungsform der Erfindung.

In den Fig 1a und 1b ist jeweils der obere Teil einer Strangführung einer Stranggießmaschine zur Erzeugung eines Strangs 2 mit Knüppelquerschnitt dargestellt. In der wassergekühlten Durchlaufkokille 1 wird kontinuierlich flüssiger Stahl zu einem Knüppel mit Querschnitt 130 x 130 mm vergossen, der in der nachfolgenden Strangführung gestützt, geführt und weiter abgekühlt wird. Dazu weist die Strangführung auf jeder Seite des Strangs 2 mehrere, in Gießrichtung nachfolgende, Strangführungsrollen 3 auf. Die Strangführungsrollen 3 selbst sind in den nachfolgenden Figuren näher darstellt. Zur Abkühlung des Strangs sind jeweils zwischen zwei aufeinanderfolgenden Strangführungsrollen 3, die derselben Seite des Strangs 2 zugeordnet sind, zwei Kühldüsen angeordnet, die jeweils rechts und links der zylindrischen Mantelfläche 8 der Rolle 3 platziert sind. Um die Figuren 1-4 nicht mit zu vielen Details zu überladen, wurde auf die zeichnerische Darstellung der Kühldüsen und der Lagerungen verzichtet; konkret wurden lediglich die Kühlmittelstrahlen 4 dargestellt, die von den Kühldüsen ausgehen. Einem Fachmann sind Einstoff- (z.B. engl. *water only* Düsen) bzw. Mehrstoff-Kühldüsen (z.B. Wasser-Luft Düsen) bestens bekannt, beispielsweise aus der DE 103 57 435 A1.

Durch die Stützung des Strangs 2 auf den vier Strangseiten wird einerseits eine unzulässige Ausbauchung der Strangschale des teilerstarrten Strangs 2 verhindert. Somit werden auch unzulässige Spannungen im Strang 2 vermieden, sodass Risse in der Strangschale als auch das sogenannte Durchbrechen des Strangs bei hohen Gießgeschwindigkeiten zuverlässig verhindert werden. Der Strang 2 wird einerseits durch den Kontakt der gegebenenfalls innengekühlten Strangführungsrollen 3 und andererseits durch die Kühlmittelstrahlen 4 (in Fig 1a sind die Kühlmittelstrahlen 4 auf einer Strangseite; in Fig 1b sind Kühlmittelstrahlen 4 auf einer anderen Strangseite, die bzgl. der Längsachse des Strangs um 90° versetzt ist, dargestellt) mit hoher Kühlintensität aber dennoch sehr gleichmäßig abgekühlt. Durch die hohe Kühlintensität der Sekundärkühlung, die zudem die Strangoberfläche sehr gleichmäßig abkühlt, und die enge Strangteilung (die Strangteilung ist der Abstand in Gießrichtung 6 zwischen zwei unmittelbar nachfolgenden Strangführungsrollen) kann die Stranggießmaschine zuverlässig auch bei sehr hohen Gießgeschwindigkeiten betrieben werden. Dadurch wird die Produktivität der Stranggießmaschine gesteigert.

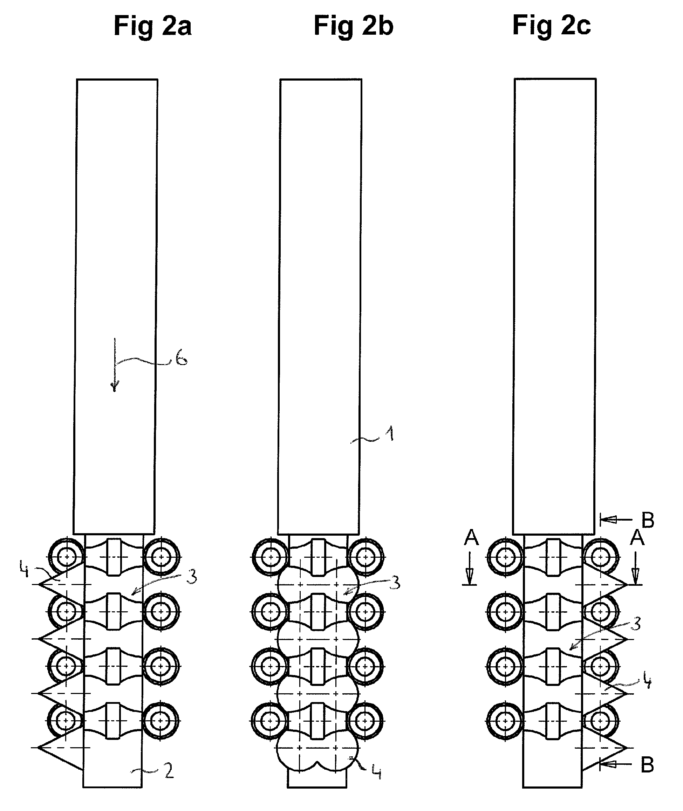

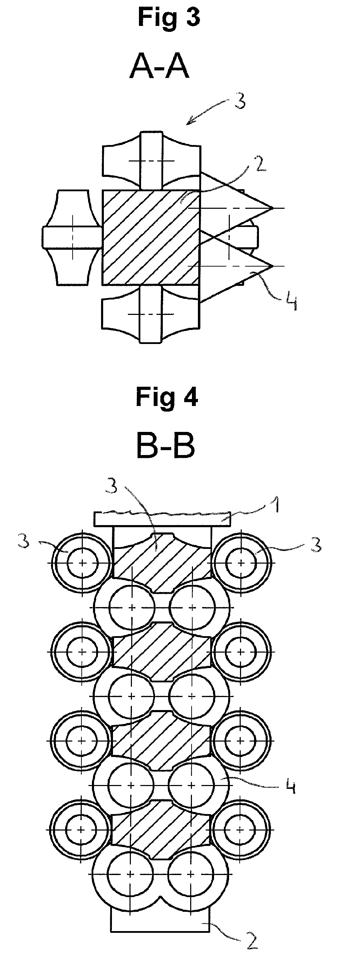

In den Fig 2a-2c ist die Strangführung der Fig 1 in einem Aufriss (Fig 2b), in einer Seitenansicht von links (Fig 2c) und in einer Seitenansicht von rechts (Fig 2a) dargestellt. Eine teilweise geschnittene Darstellung der Fig 2c entlang der Schnittlinie A-A ist in Fig 3 dargestellt. Darin ist zu erkennen, dass je eine Seitenfläche des quadratischen Knüppelstrangs 2 durch eine Mantelfläche 8 einer Strangführungsrolle 3 gestützt wird. Schließlich stellt die Fig 4 eine teilweise geschnittene Darstellung der Fig 2c entlang der Schnittlinie B-B dar.

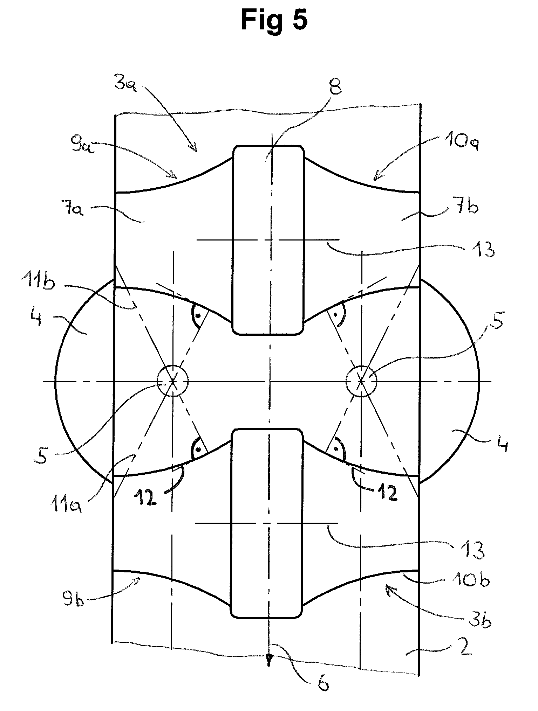

In Fig 5 ist die Strangführungsrolle 3 als auch die Anordnung von zwei nachfolgenden Strangführungsrollen in der Strangführung näher dargestellt. Konkret weist jede der beiden Strangführungsrollen 3a, 3b eine erst Stützwelle 7a, in axialer Richtung nachfolgend eine zylindrische Mantelfläche 8 und wiederum nachfolgend eine zweiten Stützwelle 7b auf. Die Mantelflächen 8 sind als Zylinderflächen ausgeführt, die die Stützwellen 7a, 7b überragen. Es wäre ebenfalls möglich, dass die Mantelfläche eine Bombierung aufweist, sodass sich eine Kante zwischen der Mantelfläche 8 und einer Stützwelle 7a, 7b nicht in die dünne Strangschale des Strangs 2 einpressen kann. Die Lagersitze der Strangführungsrollen 3a, 3b, die eine Rotation der rotationssymmetrischen Rollen um die Längsachsen 13 ermöglichen, wurden nicht dargestellt. Einem Fachmann ist aber bekannt, dass z.B. Wälz- und Gleitlager geeignet sind, die Rotation der Rolle zu ermöglichen und die auftretenden Kräfte in die Stützkonstruktion einzuleiten. Beide Strangführungsrollen 3a, 3b weisen je eine erste konkave Kontur 9a und eine zweite konkave Kontur 10a auf, die jeweils als ein Polynom zweiter oder höherer Ordnung ausgeführt ist. Die erste Kontur 9a ist in axialer Richtung vom Lagerbereich zur Mantelfläche 8 hin streng monoton steigend ausgebildet; die zweite Kontur 10a ist in axialer Richtung von der Mantelfläche 8 zum zweiten Lagerbereich hin streng monoton fallend ausgebildet. Im konkreten Fall sind beide Konturen 9a,10a als Kreisbogensegmente ausgeführt. Bekanntlich stellt nicht nur ein Kreisbogen eine Kurve zweiter Ordnung dar (Gleichung x²+y²=R², wobei x und y kartesische Koordinaten und R den Kreisradius abgeben) sondern auch Ellipsen, Parabeln etc. All diese Kurven aber auch Kurven höherer Ordnung sind prinzipiell für die ersten und zweiten Konturen 9a, 9b, 10a, 10b geeignet. In der Praxis ist es zumeist nicht sinnvoll, Kurven mit einer Ordnung > 4 zu verwenden, da die Steigungen dieser Konturen zu hoch sind.

Da sich die Strangoberfläche des Knüppels 2 mit zunehmendem Abstand von den Strangkanten mehr ausbeult, ist es günstig, den Strang 2 in der Strangmitte zu stützen. Im konkreten Fall sind nicht nur die Strangführungsrollen 3a, 3b symmetrisch zu einer vertikalen Eben, die durch die Mantelfläche 8 verläuft, ausgeführt, sondern auch die Strangführungsrollen 3a, 3b sind zur Gießachse 6 des Strangs 2 symmetrisch angeordnet. Somit wird der Strang genau in der Region gestützt, wo er sich potenziell maximal ausbauchen will. Im praktischen Betrieb hat es sich als günstig herausgestellt, die Breite der Mantelfläche 8 zwischen 10 und 50% der Breite des Knüppels 2 zu wählen; beispielsweise weist die Mantelfläche 8 eine Breite von 10 bis 100 mm auf. Dadurch wird der Strang 2 einerseits ausreichend gestützt und andererseits steht noch ausreichend Platz zur Kühlung des Strangs über die Kühlmittelstrahlen 4 der Kühldüsen 5 zur Verfügung. Gemäß dem Ausführungsbeispiel sind die Kühldüsen 5 als Vollstrahldüsen ausgeführt, die einen kreiskegelförmigen Kühlmittelstrahl 4 erzeugen. Prinzipiell wären aber auch andere Kühldüsen geeignet, beispielsweise mit einem elliptischen Spritzbild. Um ein möglichst ungehindertes Durchdringen eines Kühlmittelstrahls 4 von der Kühldüse 5 auf die Strangoberfläche zu ermöglichen, ist die Kühldüse 5 am Schnittpunkt einer ersten Normale 11a auf die Kontur 9a der ersten Strangführungsrolle 3a und einer zweiten Normale 11b auf die Kontur 9b der zweiten Strangführungsrolle 3b angeordnet. Damit wird sichergestellt, dass der Kühlmittelstrahl 4 möglichst zentrisch zwischen den beiden Konturen 9a, 9b bzw. 10a, 10b durchdringen kann.

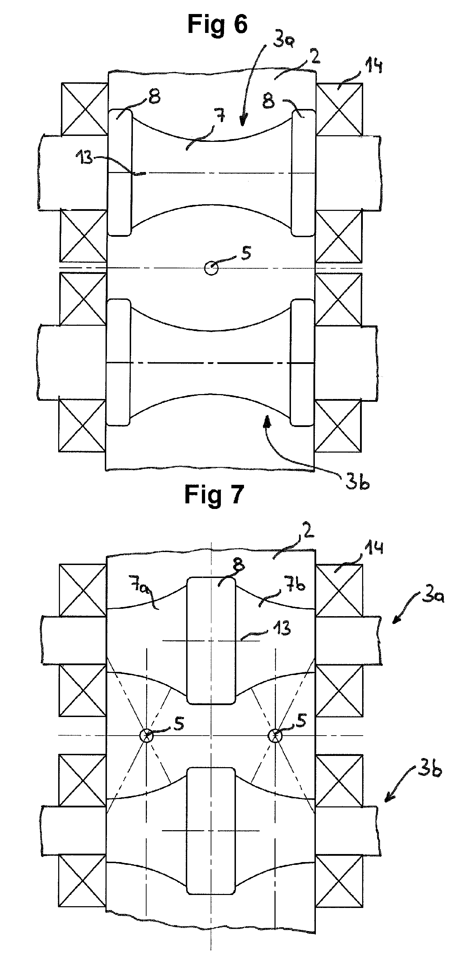

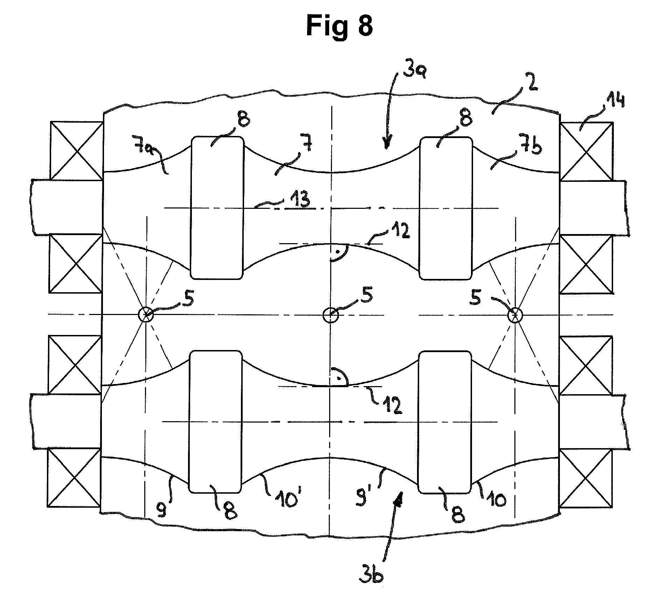

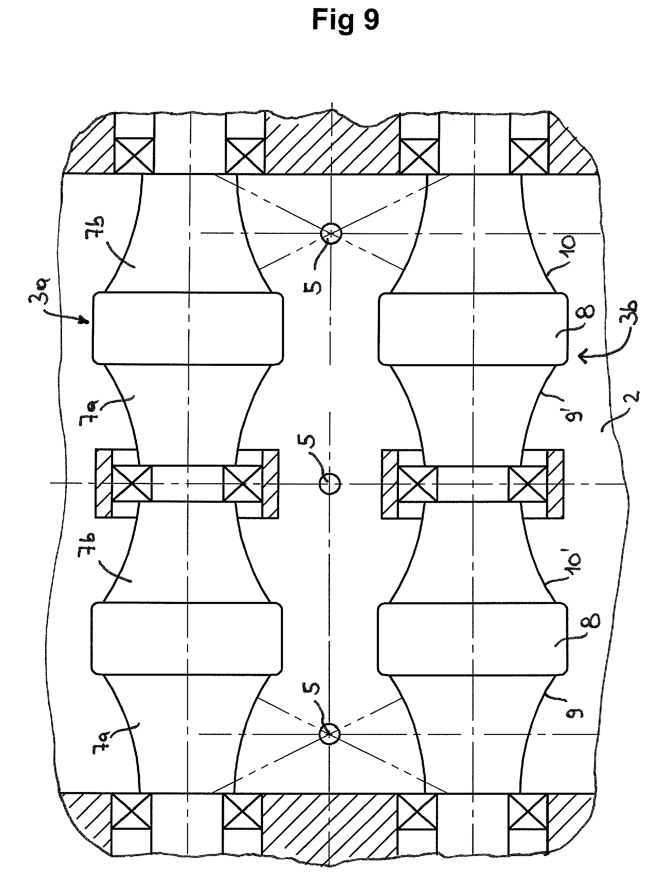

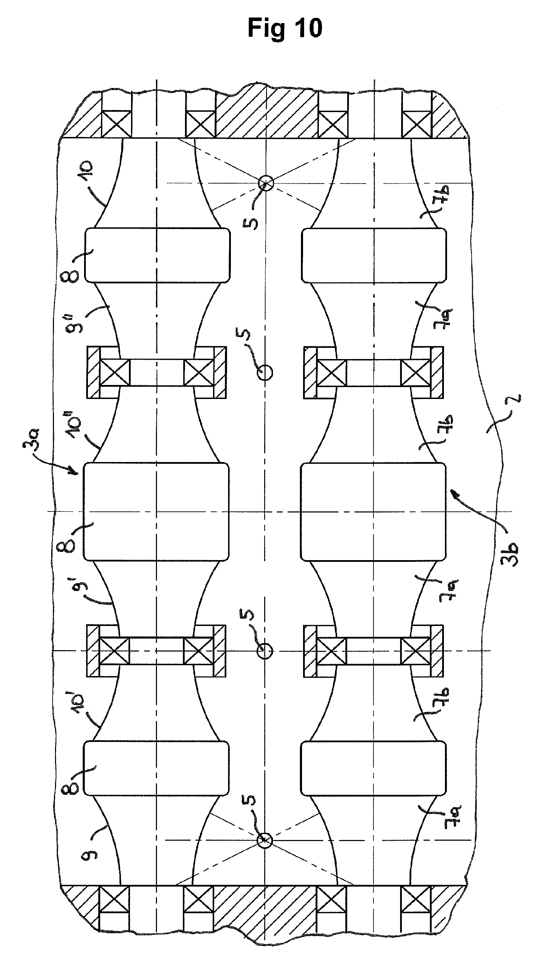

Grundsätzlich ist die Erfindung aber nicht auf eine Strangführungsrolle mit einer mittigen Mantelfläche beschränkt. Die Fig 6 bis 10 zeigen fünf unterschiedliche Varianten der Erfindung. Die Fig 6 zeigt eine erste Variante mit zwei seitlich angeordneten Mantelflächen 8 und einer mittigen Kühldüse 5. Die Fig 7 zeigt nochmals die bereits oben dargestellte Variante mit einer mittigen Mantelfläche 8 und zwei seitlich angeordneten Kühldüsen 5. Die Figur 8 stellt eine zweite Variante mit zwei seitlich angeordneten Mantelflächen 8 und drei Kühldüsen 5 dar. Die Fig 9 und 10 stellen eine dritte und eine vierte Variante mit jeweils einer mittig gelagerten Strangführungsrolle dar.

An der Variante nach Fig 6 ist günstig, dass der Strang 2 durch eine einzige, mittig angeordnete, Kühldüse 5 gekühlt werden kann. Nachteilig ist, dass die Mitte des Strangs 2 nicht durch die Mantelflächen 8 der Strangführungsrollen 3a, 3b gestützt wird.

Bei der Variante nach Fig 7 ist günstig, dass die Strangmitte durch die Mantelflächen 8 der Strangführungsrollen 3a, 3b gestützt wird. Nachteilig ist, dass zur Kühlung des Strangs 2 zwei außermittig angeordnete Kühldüsen 5 notwendig sind.

An der Variante nach Fig 8 ist günstig, dass der Strang 2 durch die drei Kühldüsen 5 sehr gleichmäßig abgekühlt werden kann. Eher nachteilig ist, dass die Strangmitte nicht durch eine Mantelflächen 8 der Strangführungsrollen 3a, 3b gestützt wird. Dies ist aber nicht weiter störend, da die Mantelflächen 8 nur geringfügig außermittig angeordnet sind, sodass die Ausbauchung der Strangmitte akzeptabel ist. Die Variante nach Fig 8 ist sowohl für Knüppel- oder Vorblockquerschnitte als auch für Brammenquerschnitte geeignet. Konkret ist zwischen den beiden Mantelflächen 8 eine weitere erste konkave Kontur 9' und nachfolgend eine weitere zweite konkave Kontur 10' angeordnet.

In Fig 9 sind eine dritte Variante der Strangführungsrolle sowie eine Strangführung zur Führung eines Strangs 2 mit Vorblock- oder Brammenquerschnitt dargestellt. Bei jeder Strangführungsrolle 3a,3b ist zwischen der weiteren zweiten Kontur 10' und der weiteren ersten Kontur 9' ein Lagerbereich angeordnet. Damit wird die maximale Durchbiegung der Rollen minimiert. Diese Ausführungsform ist insbesondere für Brammen- oder Dünnbrammenquerschnitte interessant, da diese Formate mit hoher Gießgeschwindigkeit aber dennoch geringen Ausbauchungen der Strangschale vergossen werden können.

In Fig 10 sind eine vierte Variante der Strangführungsrolle sowie eine Strangführung zur Führung eines Strangs mit Vorblock- oder Brammenquerschnitt dargestellt. Im Unterschied zu Fig 9, sind die Strangführungsrollen 3a, 3b jeweils vierfach gelagert. Die Anzahl der Lagerstellen ist i.A. beliebig, sodass eine gerade Anzahl von Lagerstellen (vgl. Figuren 6, 7, 8 und 10) als auch eine ungerade Anzahl von Lagerstellen (vgl. Fig 9) möglich sind.

### Bezugszeichenliste

- 1: Kokille
- 2: Strang
- 3,3a,3b: Strangführungsrolle
- 4: Kühlmittelstrahl
- 5: Kühldüse
- 6: Gießrichtung, Längsachse des Strangs
- 7,7a,7b: Stützwelle
- 8: Mantelfläche
- 9,9a,9b: erste konkave Kontur
- 9', 9": weitere erste konkave Kontur
- 10,10a,10b: zweite konkave Kontur
- 10',10": weitere zweite konkave Kontur
- 11a, 11b: Normale
- 12: Tangentiale
- 13: Rollenlängsachse
- 14: Lager

## Patentansprüche

1. Strangführungsrolle (3) zur Führung eines Strangs (2), aufweisend
- eine erste Stützwelle (7a) mit einem ersten Lagersitz;
- eine Mantelfläche (8), die der ersten Stützwelle (7a) in axialer Richtung nachgelagert ist;
- eine zweite Stützwelle (7b) mit einem zweiten Lagersitz, die der Mantelfläche (8) in axialer Richtung nachgelagert ist;
**dadurch gekennzeichnet,**
**dass** der Durchmesser der Mantelfläche (8) größer ist als der Durchmesser der Stützwellen (7a, 7b);
**dass** die erste Stützwelle (7a) eine erste konkave Kontur (9) aufweist, die durch ein in axialer Richtung zur Mantelfläche (8) monoton ansteigendes Polynom zweiter oder höherer Ordnung gegeben ist;
**dass** die zweite Stützwelle (7b) eine zweite konkave Kontur (10) aufweist, die durch ein in axialer Richtung von der Mantelfläche (8) monoton abfallendes Polynom zweiter oder höherer Ordnung gegeben ist.

2. Strangführungsrolle zur Führung eines Strangs (2) mit Knüppel- oder Vorblockquerschnitt nach Anspruch 1, **dadurch gekennzeichnet, dass** die Strangführungsrolle (3) genau eine Mantelfläche (8) aufweist und die erste Stützwelle (7a) symmetrisch zur zweiten Stützwelle (7b) ausgebildet ist.

3. Strangführungsrolle zur Führung eines Strangs (2) mit Vorblock- oder Brammenquerschnitt nach Anspruch 1, **dadurch gekennzeichnet, dass** die Strangführungsrolle (3) mehrere Mantelflächen (8) aufweist.

4. Strangführungsrolle nach Anspruch 1, **dadurch gekennzeichnet, dass** sich die erste Kontur (9) vom ersten Lagersitz bis zur Mantelfläche (8) erstreckt.

5. Strangführungsrolle nach Anspruch 1, **dadurch gekennzeichnet, dass** sich die zweite Kontur (10) von der Mantelfläche (8) bis zum zweiten Lagersitz erstreckt.

6. Strangführungsrolle nach Anspruch 3, **dadurch gekennzeichnet, dass** zwischen zwei Mantelflächen (8) eine weitere zweite Kontur (10') und nachfolgend eine weitere erste Kontur (9') angeordnet sind.

7. Strangführungsrolle nach Anspruch 6, **dadurch gekennzeichnet, dass** zwischen der weiteren zweiten Kontur (10') und der weiteren ersten Kontur (9') ein Lagerbereich angeordnet ist.

8. Strangführungsrolle nach einem der vorhergehenden Ansprüche, **dadurch gekennzeichnet, dass** die Strangführungsrolle (3) eine Innenkühlung aufweist.

9. Strangführungsrolle nach Anspruch 8, **dadurch gekennzeichnet, dass** die Innenkühlung einen Kühlmittelkanal aufweist, der sich in axialer Richtung erstreckt.

10. Strangführung zur Führung und Kühlung eines Strangs (2), aufweisend
- eine erste Strangführungsrolle (3a) nach einem der Ansprüche 1 bis 9, die zumindest eine konkave Kontur (9a, 10a) aufweist;
- eine zweite Strangführungsrolle (3b) nach einem der Ansprüche 1 bis 9, die zumindest eine weitere konkave Kontur (9b, 10b) aufweist, wobei beide Strangführungsrollen (3a, 3b) derselben Seite des Strangs (2) zugeordnet sind und die zweite Strangführungsrolle (3b) der ersten Strangführungsrolle (3a) in Gießrichtung (6) nachgelagert ist; und
- zumindest eine Kühldüse (5) zum Aufbringen eines Kühlfluids auf dieselbe Seite des Strangs (2), wobei die Kühldüse (5) in Gießrichtung (6) zwischen der ersten (3a) und der zweiten Strangführungsrolle (3b) angeordnet ist;
**dadurch gekennzeichnet, dass** die Kühldüse (5) in einem Schnittpunkt angeordnet ist, der durch eine erste Normale (11a) auf die konkave Kontur (9a, 10a) der ersten Strangführungsrolle (3a) und eine zweite Normale (11b) auf die weitere konkave Kontur (9b, 10b) der zweiten Strangführungsrolle (3b) bestimmt ist.

11. Strangführung nach Anspruch 10, **dadurch gekennzeichnet, dass** die erste (3a) und zweite (3b) Strangführungsrolle jeweils eine kreisbogenförmige konkave Kontur (9a,9b,10a,10b) aufweist, sodass die Kühldüse (5) im Mittelpunkt der beiden Konturen angeordnet ist.

12. Strangführung nach einem der Ansprüche 10 oder 11, **dadurch gekennzeichnet, dass** die Strangführungsrollen (3a, 3b) symmetrisch zu einer Längsachse (6) des Strangs (2) angeordnet ist.
